# EUROPEAN PATENT APPLICATION

(11) **EP 3 511 978 A1**
(43) Date of publication of application: **17.07.2019**
(21) Application number: 18211195.5
(22) Date of filing: 07.12.2018
(51) Int. Cl.: H01L 23/28, H01L 23/433, H01L 25/00, H01L 25/065, H01L 25/16, H01L 25/18, H01L 23/16

(54) **STACKED DIE ARCHITECTURES WITH IMPROVED THERMAL MANAGEMENT**

(30) Priority: 10.01.2018 US 201815866793
(71) Applicant: INTEL Corporation, Santa Clara, CA 95054 (US)
(72) Inventor: EID, Feras, Chandler, AZ 85226 (US); KOTHARI, Shrenik, Chandler, AZ 85226 (US); JHA, Chandra M., Chandler, AZ 85226 (US); SWAN, Johanna M., Scottsdale, AZ 85255 (US); BAKER, Michael J., Gilbert, AZ 85297 (US); LIFF, Shawna M., Gilbert, AZ 85295 (US); SOUNART, Thomas L., Chandler, AZ 85226 (US); GEBREHIWOT, Betsegaw K., Chandler, AZ 85224 (US); DEVASENATHIPATHY, Shankar, Tempe, AZ 85284 (US); GAINES, Taylor, Phoenix, AZ 85044 (US); RAORANE, Digvijay Ashokkumar, Chandler, AZ 85248 (US)
(74) Representative: 2SPL Patentanwälte PartG mbB

(57) **Abstract**

A semiconductor device that has a semiconductor die coupled to a substrate. A mold compound encapsulates the semiconductor die, and at least one thermal conductive material section extends from adjacent the semiconductor die through the mold compound. The at least one conductive material section thus conveys heat from the semiconductor die through the mold compound.

## Description

### TECHNICAL FIELD

This document pertains generally, but not by way of limitation, to packaging for computing system components. More specifically, this document pertains to providing improved thermal qualities to packaging architecture.

### BACKGROUND

Manufacturing components for computing devices involves rigorous manufacturing processes that involve placing, or packaging numerous electric materials onto a substrate to create electrical components such as semiconductors, integrated circuits (ICs), chips, and the like. The electrical material is often referred to as a die that is electrically coupled to the substrate in any conventional manner, including but not limited to, wire bonding and flip chip bonding. Such electrical components are then utilized in memory devices, modern processors, such as a central processing unit (CPU), a graphics processing unit (GPU), advanced processing unit (APU), or combinations thereof, and the like.

When such components are manufactured, numerous electrical and mechanical considerations must be taken into account to create a viable end product. Such considerations include, but are not limited to, physical damage, mechanical vibrations, thermal properties, electrical properties such as electric and magnetic fields, electrostatic discharge, and the like. Packaging refers to the process of manufacturing and encapsulating, or protecting the electric material and substrate in order to account for these and other electrical and mechanical properties.

Through advances in packaging technologies stacked die packages have been created. Stacked die packages provide for a first die that is electrically coupled to the substrate through typical means, and a second die that is stacked on and electrically coupled to the first die through conventional means including wire bonding and flip chip bonding. Such packages provide for improved spatial properties, electrical operation, and more efficient manufacturing processes. Still, these packages present challenges related to improving thermomechanical and electrical characteristics while presenting efficient manufacturing processes.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
Fig. 1 is a top plan view of a stacked die package in accordance with an example embodiment.
Fig. 2 is a sectional view of a stacked die package taken along the lines 2-2 of Fig. 1 in accordance with an example embodiment.
Fig. 3 is a sectional view of a stacked die package taken along the lines 3-3 of Fig. 1 in accordance with an example embodiment.
Fig. 4 is a top plan view of a stacked die package in accordance with an example embodiment.
Fig. 5 is a sectional view of a stacked die package taken along the lines 5-5 of Fig. 4 in accordance with an example embodiment.
Fig. 6 is a sectional view of a stacked die package taken along the lines 6-6 of Fig. 4 in accordance with an example embodiment.
Fig. 7 is a top plan view of a stacked die package in accordance with an example embodiment.
Fig. 8 is a sectional view of a stacked die package taken along the lines 8-8 of Fig. 7 in accordance with an example embodiment.
Fig. 9 is a sectional view of a stacked die package taken along the lines 9-9 of Fig. 7 in accordance with an example embodiment.
Fig. 10 is a top plan view of a stacked die package in accordance with an example embodiment.
Fig. 11 is a section view of a stacked die package similar to that of FIGs 3, 6, and 9 in accordance with an example embodiment.
Fig. 12 is a section view of a stacked die package similar to that of FIGs. 3, 6, and 9 in accordance with an example embodiment.
Fig. 13 is a section view of a stacked die package similar to that of FIGs. 3, 6, and 9 in accordance with an example embodiment.
Fig. 14 is a block flow diagram of a method of manufacturing a stacked die package in accordance with an example embodiment.
Fig. 15 is a block flow diagram of a method of manufacturing a stacked die package in accordance with an example embodiment.
Fig. 16 is a block diagram of example devices in accordance with an example embodiment.

### DETAILED DESCRIPTION

Within a stacked die package, electrical components operate with current running through the components, thus generating a significant amount of heat that may be detrimental to the proper functioning of the electrical component if not properly dissipated. Components of any package are made from materials that have threshold temperatures for operating at maximum reliability or performance limits. Thus, as heat is generated by the components, the heat must be conveyed away from the components at a rate to keep all regions within a package below such threshold temperatures to avoid premature material failures, power leakages, and reduction in overall performance of the electrical component.

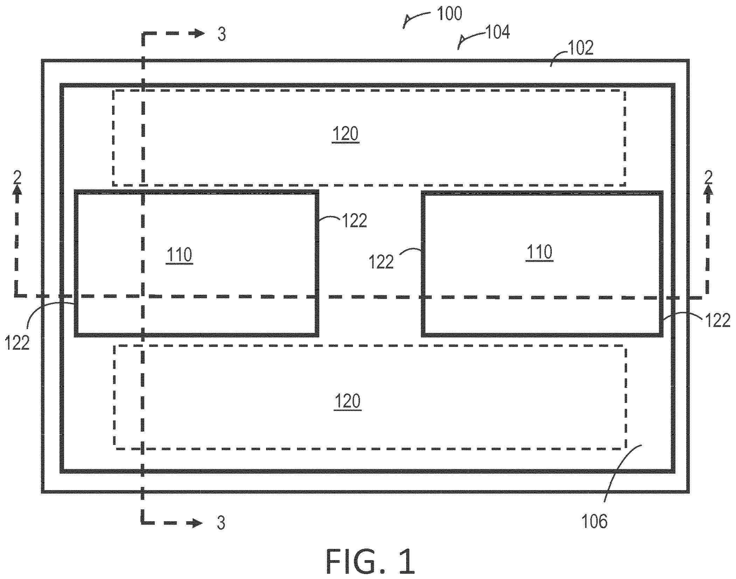

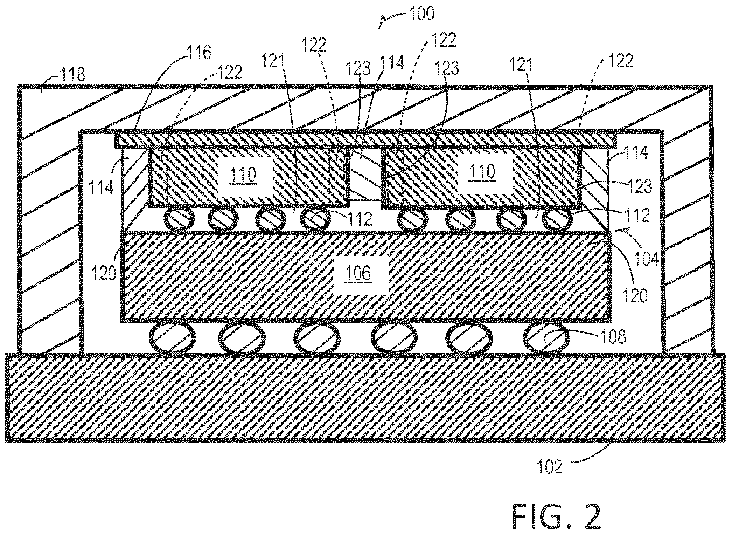

Figs. 1-3 show a stacked die package 100. The package includes a substrate 102 that receives and is coupled to a plurality of electronic components 104, including but not limited to semiconductor dies, electronic pad elements, traces, and the like. In this example the electronic components 104 include a bottom semiconductor die 106 coupled to the substrate 102 through any known means. This includes through flip chip bonding where electrical connection is through solder bumps 108, as shown, or wire bonding.

Top semiconductor dies 110 are stacked, or coupled on top of the bottom semiconductor die 106. Again, coupling is done in any conventional manner including flip chip bonding where electrical connection is through solder bumps 112 as shown, or wire bonding. While the FIGs illustrate two top semiconductor dies 110 on a bottom semiconductor die, numerous spaced apart side-by-side top semiconductor dies 110 may be arranged on top of the bottom semiconductor die 106 without falling outside of this disclosure.

A mold layer 114 encapsulates the electronic components, including the bottom and top semiconductor dies 106, 110 for mechanically protecting the components. The mold layer 114 prevents wear from external elements to increase the life of the package 100. The mold layer 114 also functions to convey heat from the electronic components 104 on the substrate 102 to a thermal interface material layer 116 of a heat spreader 118. The heat spreader 118 is coupled to the substrate 102 and surrounds the electronic components 104. In the example of FIGs. 1-3 the thermal interface material layer 116 engages the top surface of the top semiconductor dies 110 to provide an efficient thermal interface directly from the top semiconductor dies 110 to the heat spreader 118.

The package 100 of FIGs. 1-3 has limitations when conveying heat from within the package to the heat spreader 118. While the semiconductor dies 106 and 110 are good thermal conductors, areas within the stacked package where heat escapes from the semiconductor dies 106, 110 must be conveyed from the individual semiconductor die through the mold layer 114, which generally has a low thermal conductivity (e.g., 2 orders of magnitude less than the die). Therefore, when heat conveyance is restricted and the heat is unable to be conveyed through the mold layer 114 in an efficient manner, the heat builds within the individual semiconductor dies at these locations. These regions within the semiconductor dies are often referred to as hot spots.

A first hot spot region is within the bottommost semiconductor die of a two layer semiconductor die stacked arrangement and is referred to as an underhang region 120. The term "underhang region(s)" when used in this disclosure is defined as areas within a bottommost semiconductor die of a two layer semiconductor die stacked arrangement that are not covered by a topmost semiconductor die of the two layer semiconductor die stacked arrangement. In particular, the bottommost semiconductor die and topmost semiconductor die of a two layer semiconductor die arrangement define an interface surface 121 where heat is conveyed from the bottommost semiconductor die to the topmost semiconductor die. The underhang regions exist in areas of the bottommost semiconductor die where no such heat conveyance exists.

A second hot spot region in a stacked die package such as that illustrated in the example of FIGs. 1-3 is referred to as an edge region 122. The term "edge region(s)" when used in this disclosure is defined as areas within a topmost semiconductor die of a two layer semiconductor die stacked arrangement at the exposed edge surfaces 123 of the topmost semiconductor die. In particular, in a stacked die arrangement the bottom surface of the topmost semiconductor die engages the top surface of the bottommost semiconductor die. Meanwhile, the top surface of a topmost semiconductor die often engages the thermal interface material layer 116 of a heat spreader 118. However, the edge surfaces 123 do not interface with any component other than the molding compound or an underfill material, both of which generally have low thermal conductivities.

A two layer semiconductor die stacked arrangement as described in defining the underhang region and edge region above includes a bottommost semiconductor die representing a first layer of the arrangement, and at least one topmost semiconductor die stacked on top of the bottommost semiconductor die representing a second layer. In the example of FIGs. 1-3 the second layer includes two topmost semiconductor dies. Therefore in this example, the underhang region includes all areas of the bottommost semiconductor die that do not interface with one of the first or second topmost semiconductor dies.

While in the example of FIGs. 1-3 only two layers are presented, in other examples or embodiments additional stacked die layers exist. In such examples where an intermediary semiconductor die layer(s) exists, when determining underhang regions and edge regions of a specific semiconductor die, an intermediary semiconductor die (that is not the bottommost semiconductor die of the entire stacked die package) that receives one or more stacked semiconductor dies on its top surface is considered the bottommost semiconductor die of a two layer semiconductor die stacked arrangement (the first layer being formed by the intermediary semiconductor die and the second layer being formed by the one or more stacked dies thereon). Meanwhile, the stacked semiconductor die or dies on the top surface of the intermediary semiconductor die that interface with the intermediary semiconductor die are considered the topmost semiconductor die(s) of the two layer semiconductor die arrangement.

One manner to address the hot spots in the regions 120, 122 is to select a mold material with a relatively high thermal conductivity. However, when selecting a mold material, numerous design constraints such as thermal properties, adhesion to silicon or other package materials, coefficient of thermal expansion (CTE), Young's modulus, cohesive strength, or the like, must be taken into account. This limits thermal conductance characteristics of the mold material. Therefore, even when the material of the mold is selected to have good thermal conductivity, to meet other requirements of the mold, at best the thermal conductivity is in a range between 3-6 Watts per Meter Kelvin at 25°C (W/m-K). While this improves thermal conductivity, the mold still acts as a thermal bottleneck, and additionally creates other difficulties in manufacturing such as void creation in the mold layer, assembly and test equipment wear, and package failure.

As one example, to achieve improved thermal conductivity, the mold layer 114 is made with abrasive ceramic based particles such as aluminum oxide (Al2O3). Not only do those particles deter flow and create difficulties during molding and any subsequent grinding steps due to their high concentration in the mold resin, but they also wear down the test head and other testing equipment due to their abrasive nature. Such wear leads to inaccurate readings and the need to replace testing equipment prematurely.

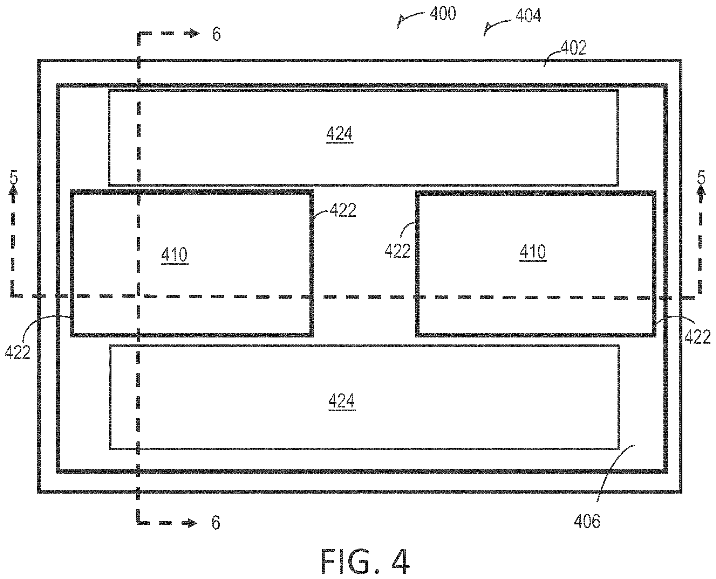

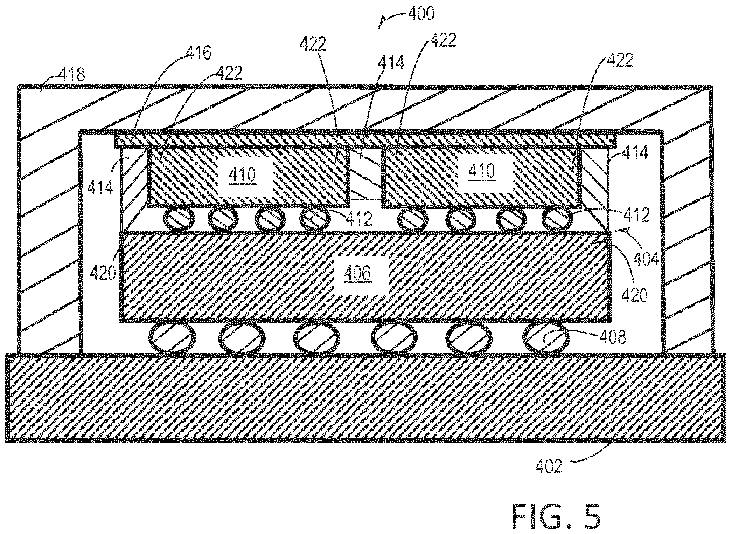

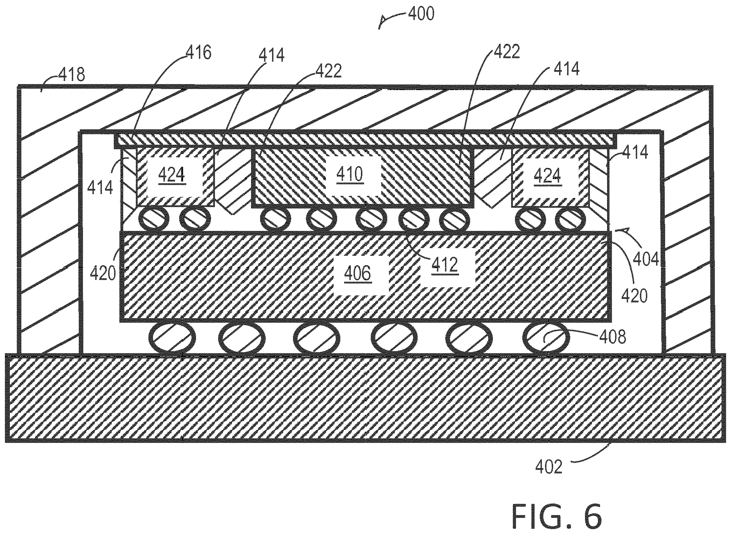

FIGs. 4-6 illustrate an example of a stacked die package 400 that attempts to overcome deficiencies of the embodiments of FIGs 1-3. The package 400 similar to the embodiment of FIGs. 1-3 includes a substrate 402, electrical components 404 including bottom semiconductor die 406, solder bumps 408, top semiconductor die 410, and solder bumps 412, a mold layer 414, thermal interface material layer 416, and heat spreader 418 arranged and coupled similarly as shown in FIGs. 1-3. Thus, hot spots are presented within underhang regions 420 and edge regions 422 of the semiconductor dies 406, 410 as described in relation to the embodiment of FIGs. 1-3.

In this embodiment, during the manufacturing process, additional semiconductor dies 424 are placed on the bottom semiconductor die 406 adjacent either side of the top semiconductor dies 410. These additional semiconductor dies 424 are not electrically active and are only provided to improve the conveyance of heat from the electrical components 404. Consequently, these additional semiconductor dies 424 are referred to as dummy dies.

Dummy dies 424 are typically made from silicon and thus have a high thermal conductivity of approximately 120 W/m-K. After placement of the dummy dies 424, the mold layer 414 is applied for additional protection for the electrical components 404. By improving the thermal conductivity of the material that conveys heat from the electrical components 404 within the package, thermal properties are better managed and thermally induced failures are minimized.

Still, while dummy dies 424 help mitigate some of the thermal problems of the package, forming a plurality of dies that are small enough to be positioned adjacent to the top semiconductor dies 410 is expensive. Specifically, the dummy die wafers must be singulated during manufacturing. Then, in addition, these singulated dummy dies must be precisely placed on the bottom semiconductor die 406 adjacent the top semiconductor dies 410 in the desired region. This is tedious, expensive, inefficient, and difficult to manage. Additionally, placement of such dummy dies 424 adjacent to edge regions 422 is problematic as a result of size constraints of the dies. Thus, hot spots remain in these regions.

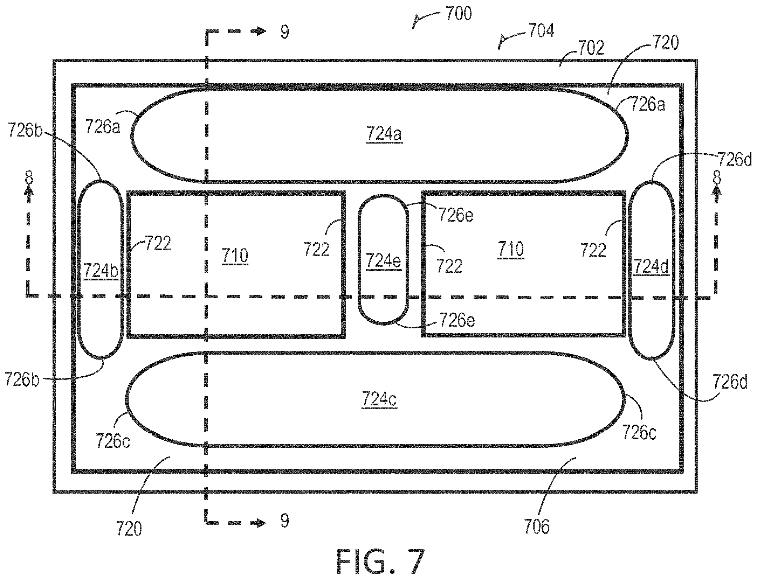

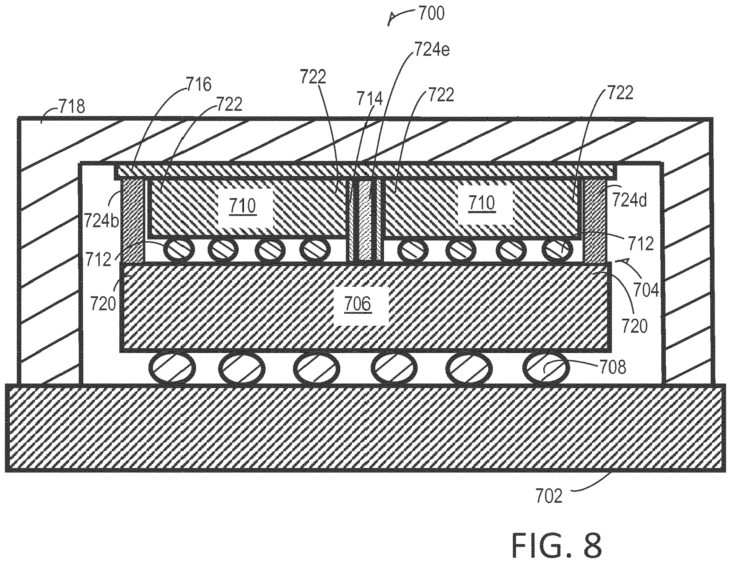

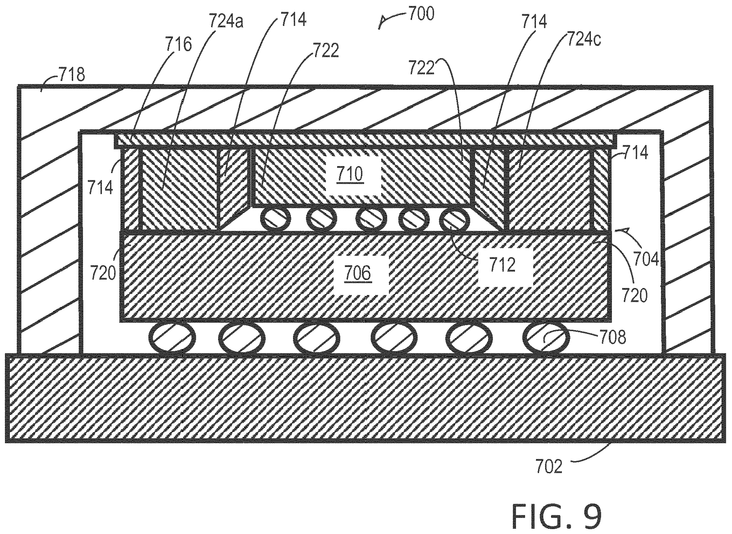

Figs. 7-9 illustrate an example of a stacked die package 700 that overcomes deficiencies of the embodiments of both FIGs 1-3 and 4-6. The package 700 similar to the examples of Figs. 1-3 and 4-6 also include a substrate 702, electrical components 704 including bottom semiconductor die 706, solder bumps 708, top semiconductor die 710, solder bumps 712, a mold layer 714, thermal interface material layer 716, and heat spreader 718 arranged and coupled similarly as shown in Figs. 1-3 and 4-6. Thus, again, hot spots are presented within underhang regions 720 and edge regions 722 of the semiconductor dies 706, 710 as described in relation to the embodiment of FIGs. 1-3 and 4-6.

In this example, during manufacturing, thermal conductive material sections 724 are applied in selected areas within the package 700 to convey heat from the hot spot regions 720, 722 to the thermal interface material layer 716 of the heat spreader 718. The thermal conductive material sections 724 are applied using any known deposition method. These include, but are not limited to dispensing, screen printing, stencil printing, or the like. Also included is applying and curing the thermal conductive material sections 724 in the pre-selected areas prior to applying the mold of the mold layer 714. In such application, after the mold layer 714 is applied, back grinding is carried out to expose the top semiconductor die(s) 710, consequently exposing the thermal conductive material sections 724.

Alternatively, the thermal conductive material sections 724 are applied after application of the mold layer 714 and back grinding. In such an embodiment, cavities are created in the mold corresponding to the regions which are to be filled by the thermal conductive material section 724. This is accomplished through use of a mold chase with protruding pedestals, by patterning and etching the mold, or the like. The cavities are then filled with the thermal conductive material of the sections 724 through dispensing, screen printing, stencil printing, or the like and the material is cured to form the sections 724. If needed, backgrinding of the sections 724 can additionally be applied to level the package 700.

In yet another embodiment, the thermal conductive material sections 724 are applied through a metal plating process. Specifically, plated metal is applied by inserting the package in a plating bath during the manufacturing process. Thus, in each example the thermal conductive material sections 724, regardless of the material utilized, is applied during a single manufacturing step simplifying manufacturing.

In this example, after the thermal conductive material sections 724 are applied, the heat spreader 718 is coupled to the thermal conductive material sections 724 and top semiconductor die(s) 710. In one embodiment, the thermal interface material (TIM) of the thermal interface layer 716 includes polymer based or solder based TIMs with corresponding metallization on the top semiconductor die and thermal conductive section top surfaces to form a permanent joint with the heat spreader 718.

The thermal conductive material of sections 724 in one example is a conductive paste made from a combination of polymer and thermally conductive particles. In one example, the polymer can be an epoxy resin. In one example, the conductive particles can be metal, including, but not limited to, silver, silver-coated copper, copper, aluminum, and the like. Such conductive paste may have a thermal conductivity in the range between 10-25 W/m-K. In another example, the thermal conductive material is a sintering metal paste. In yet another example, the thermal conductive material is plated metal. In each example, the thermal conductive material has greater thermal conductivity than the material of the mold layer 714.

In addition to each section 724 being applied in any manner as discussed above, and being comprised of a material with a greater thermal conductivity than the mold layer, each section 724 is of any size, shape, or position within the package as needed. Specifically, the amount of sections 724, and the size, length, width, depth, shape, and location are all pre-selected prior to dispensing, plating, or printing the sections 724 into the package. As an example, the sections may vary in having a thickness in a range between approximately 50µm-200µm and in-plane (xy) feature sizes of approximately 50µm-1000µm.

Considerations for such pre-selections are package characteristics that include, but are not limited to, locations of hot spots, ease of manufacturing, expense of materials, number of top semiconductor dies, implementation of additional stacked semiconductor die layers, positioning of heat spreader compared to top semiconductor die layer, electrical bonding of semiconductor die layers, and the like.

In the example of FIGs. 7-9, five sections 724a, 724b, 724c, 724d, and 724e are provided. Each section 724a, 724b, 724c, 724d, 724e includes arcuate end walls 726a, 726b, 726c, 726d, 726e and extends through the mold layer 714 from the bottom semiconductor die 706 adjacent the top semiconductor dies 710 to the thermal interface material layer 716 of the heat spreader 718. Specifically, two of the sections 724a, 724c are in parallel spaced relation and extend over the underhang regions 720 in the bottom semiconductor die 706 where the dummy dies of the embodiment of FIGs 4-6 were located. The other three sections 724b, 724d, 724e similarly are in parallel spaced relation and have a longitudinal direction that is perpendicular to the longitudinal direction of each of the two sections 724a, 724c extending over the under hang region 720. These three sections 724b, 724d, 724e are thus adjacent edge regions 722 within the top semiconductor die 710 in areas in which dummy dies of the embodiment of FIGs 4-6 could not be placed.

The table below shows test results from a comparison of the example of FIGs. 7-9 using the thermal conductive material sections 724 in first and second regions 720, 722 to improve thermal conduction in the first and second regions versus the embodiment of FIGs. 4-6 utilizing dummy dies.

| Table 1 | Max temp in Region 1 | Max temp in Region 2 |
|---|---|---|
| Dummy Si + high conductivity mold | 84C | 107C |
| High conductivity paste | 89C | 102C |

In the test, the thermal conductive material sections 724 were formed of a thermal conductive paste having a thermal conductivity of approximately 20 W/m-K. The maximum temperature for the underhang regions (Region 1 in table) and edge regions (Region 2 in table) as described in above embodiments were taken during operation. In the underhang region, because the thermal conductivity of silicon is approximately 120 W/m-K and higher than the thermal conductivity of the paste material, the maximum temperature was 5 degrees higher when using the paste material - 89C vs 84C. However, in the edge regions where the dummy dies are impractical to place, the maximum temperature is 5 degrees higher for the FIG. 4-6 embodiment compared to the embodiment of FIGs. 7-9 - 107C vs 102C.

Importantly, in examples where the components within the packages 400 or 700 have a threshold temperature typically around 105 C, where above the threshold temperature thermally induced failures begin to occur, by decreasing the temperature from 107 C to 102 C, the components remain within their allowable thermal operating range. Consequently, by applying the high conductivity paste during manufacturing instead of using dummy dies, the package 700 stays below the threshold temperature of components preventing or minimizing thermally related risks within the package.

Thus provided is a package 700 with improved heat characteristics as compared to the package 100 of FIGs. 1-3. Because of the use of the thermal conductive material sections 724, the mold material of the package 700 is selected or optimized based on other mechanical and processing properties such as modulus, CTE, viscosity, spiral flow length, or the like, without regard to its thermal conductivity, thus improving the overall package 700. The package 700 is also formed using a manufacturing method that eliminates the multi-step, time consuming, and expensive process of forming, singulating, and placing dummy dies on a substrate. Instead, thermal conductive material sections 724 are applied within the package 700 in a single manufacturing step. Thus an improved overall package 700 is presented compared to the embodiments provided in both FIGs 1-3 and 4-6.

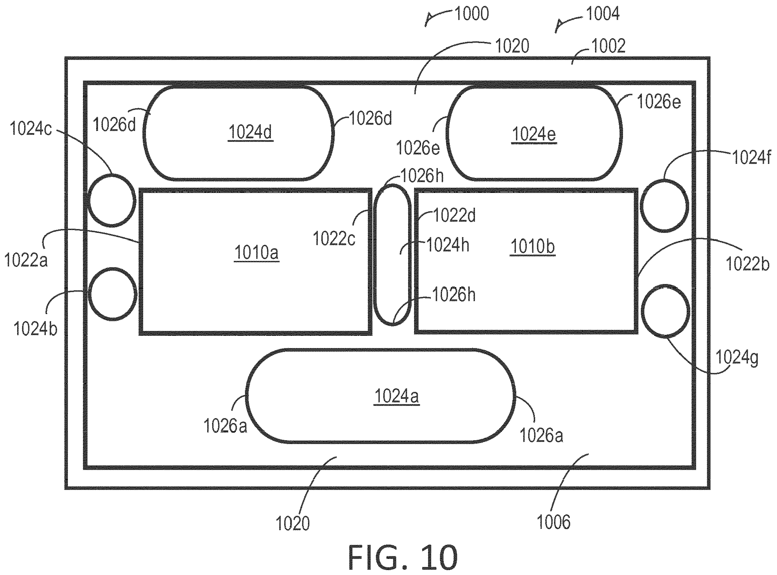

Fig. 10 illustrates another example of a stacked die package 1000 that overcomes deficiencies of the embodiments of FIGs 1-3 and 4-6. Fig. 10 specifically provides numerous examples of how thermal conductive material sections of different sizes, shapes, and positions may be utilized to improve thermal properties of a package 1000 and are contemplated by this disclosure. Consequently, this embodiment is only provided in a top view as provided in FIGs. 1, 4, and 7.

In this example, the package 1000 similar to the examples of Figs. 1-3, 4-6, and 7-9 also includes a substrate, electrical components 1004 including bottom semiconductor die 1006, top semiconductor dies 1010a, 1010b, solder bumps, a mold layer, thermal interface material layer, and heat spreader arranged and coupled similarly as shown in Figs. 1-3, 4-6, and 7-9. Thus, again, hot spots are presented within underhang regions 1020 and edge regions 1022 of the semiconductor dies 1006, 1010a, 1010b as described in relation to the embodiment of FIGs. 1-3, 4-6, and 7-9. Because the example of FIG. 10 is provided to show example positions, sizes, and shapes of thermal conductive material sections, only the bottom semiconductor die 1006, top semiconductor dies 1010a, 1010b, and sections 1024a-1024h are illustrated.

In this example, during manufacturing, thermal conductive material sections 1024a-1024h are applied in selected areas within the package 1000 to convey heat from the hot spot regions 1020, 1022 to the thermal interface material layer of the heat spreader. In this embodiment eight separate sections 1024a-1024h are applied within the mold layer. Each section 1024a-1024h extends from adjacent the bottom semiconductor die 1006 to the thermal interface material layer of the heat spreader.

Specifically, a first section 1024a, similar to the sections of the embodiment of FIGs. 7-9, is elongated with arcuate end walls 1026a. The first section 1024a is positioned to extend from adjacent a first top semiconductor die 1010a to adjacent a second top semiconductor die 1010b.

Second and third sections 1024b and 1024c are both generally cylindrical in shape. The second and third sections 1024b, 1024c are also positioned in side by side spaced alignment adjacent an edge region 1022a of the first top semiconductor die 1010a.

A fourth section 1024d and fifth section 1024e both similar to first section 1024a are elongated with arcuate end walls 1026d and 1026e. The fourth section and fifth section 1024d and 1024e are positioned in spaced alignment from one another on the opposite side of the top semiconductor dies 1010a, 1010b as compared to the first section 1024a. However, the fourth section 1024d extends adjacent only the first top semiconductor die 1010a, while the fifth section 1024e extends adjacent only the second top semiconductor die 1010b.

Sixth and seventh sections 1024f and 1024g are both generally cylindrical in shape. The sixth and seventh sections 1024f, 1024g are also positioned in side by side spaced alignment adjacent an edge region 1022b of the second top semiconductor die 1010b. In this manner the sixth and seventh sections 1024f and 1024g are positioned on an opposite side of the package 1000 as compared to the second and third sections 1024b and 1024c.

An eighth section 1024h, similar to first, fourth, and fifth sections 1024a, 1024d, and 1024e is elongated with arcuate end walls 1026h. However, this section 1024h has a longitudinal direction that is perpendicular to the longitudinal directions of each of the first, fourth, and fifth sections 1024a, 1024d, and 1024e. To this end, the eighth section 1024h extends between the first and second top semiconductor dies 1010a and 1010b adjacent edge regions 1022c and 1022d of the first and second top semiconductor dies 1010a and 1010b, similar to section 724e of FIG. 7.

Thus, as can be seen in the illustration of FIG. 10, the position, size, and shape of each thermal conductive material section 1024a-h may vary based on packaging needs. Thus, the position, size, and shape of each section are selected based on package characteristics as previously discussed and applied during a single manufacturing process. The position, size, and shape of each section can also be different from the examples shown in FIG. 10.

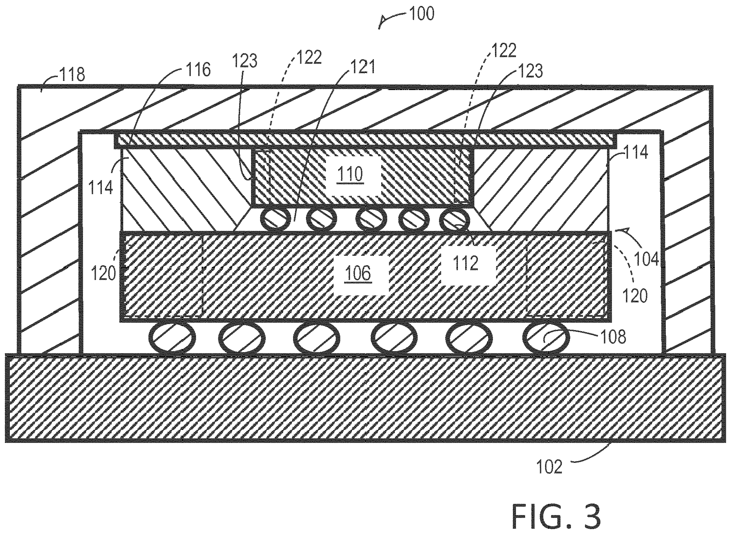

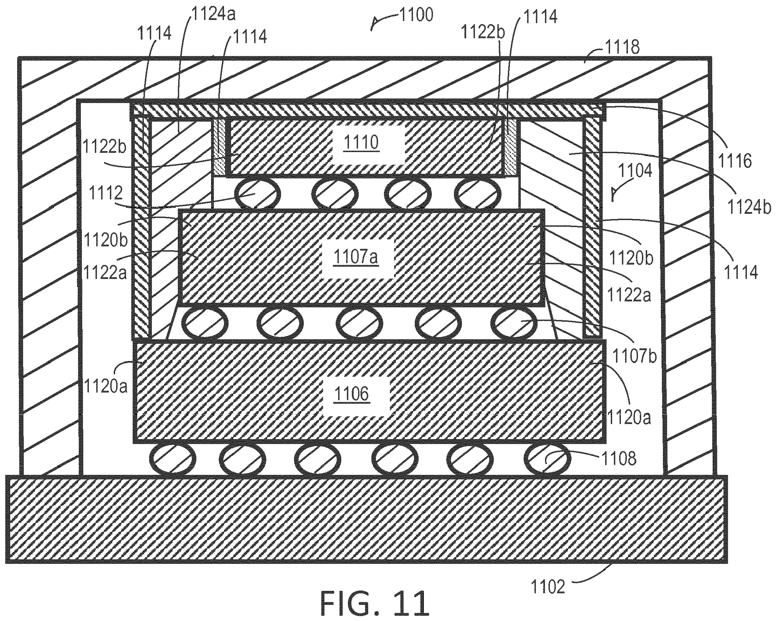

While FIGs. 7 and 10 illustrates numerous examples of positions, sizes, and shapes that sections 724a-724e and 1024a-1024h may have in forming packages 700 and 1000, FIGs. 11-13 illustrate numerous examples of stacked packages that may use such sections 724a-724e and 1024a-1024h to improve thermal properties of the package. Consequently, additional positions, sizes, and shapes are provided. While each of the FIGs. 11-13 is only shown as a section view similar to FIGs. 3, 6, and 9, it is understood that additional thermal conductive material sections as provided in other examples similarly exist in the example packages of FIGs 11-13.

Thus, FIG. 11 illustrates a stacked die package 1100 that overcomes deficiencies described in relation to the embodiments of FIGs 1-3 and 4-6. In this embodiment, the package 1100 presents 3 stacked dies. Specifically, the package 1100 similar to the examples of previous figures, also includes a substrate 1102, electrical components 1104 including bottom semiconductor die 1106 and solder bumps 1108 electrically coupling the bottom semiconductor die 1106 to the substrate 1102. In other embodiments the bottom semiconductor die 1106 may also be wire bonded to the substrate 1102.

In this example, the electrical components 1104 also include an intermediary semiconductor die 1107a that is electrically coupled to the bottom semiconductor die 1106 through any means. This includes through solder bumps 1107b using flip chip bonding as shown, or through wire bonding. A top semiconductor die 1110 is then electrically coupled to the intermediary semiconductor die 1107a through any manner including solder bumps 1112 using flip chip bonding as shown, or through wire bonding.

The package 1100 also includes a mold layer 1114, thermal interface material layer 1116, and heat spreader 1118 coupled and positioned similar to previous examples and embodiments with the thermal interface material layer 1116 of the heat spreader 1118 engaging the top semiconductor die 1110. In this package 1100, hot spots are presented within the bottom semiconductor die underhang regions 1120a and the intermediary semiconductor die underhang regions 1120b. Hot spots are also presented within intermediary semiconductor die edge regions 1122a and top semiconductor die edge regions 1122b.

In this example, during manufacturing, thermal conductive material sections 1124a, 1124b are applied in selected areas within the package 1100 to convey heat from the hot spot regions 1120a, 1120b, 1122a, 1122b to the thermal interface material layer 1116 of the heat spreader 1118. In this embodiment, thermal conductive material sections 1124a, 1124b each interface with and extend from the bottom semiconductor die 1106 toward the intermediary semiconductor die 1107a to adjacent an edge region 1122a of the intermediary semiconductor die 1107a. The thermal conductive material sections 1124a and 1124b additionally interface with and extend from the intermediary semiconductor die top surface toward the top die 1110 to the thermal interface material layer 1116 of the heat spreader 1118. Thus again, the size and shape of the sections 1124a, 1124b may vary based on requirements of the package 1100. In other examples of a three stacked die arrangement, separate spaced sections may interface with and extend from both the bottom semiconductor die 1106 and intermediary semiconductor die 1107a.

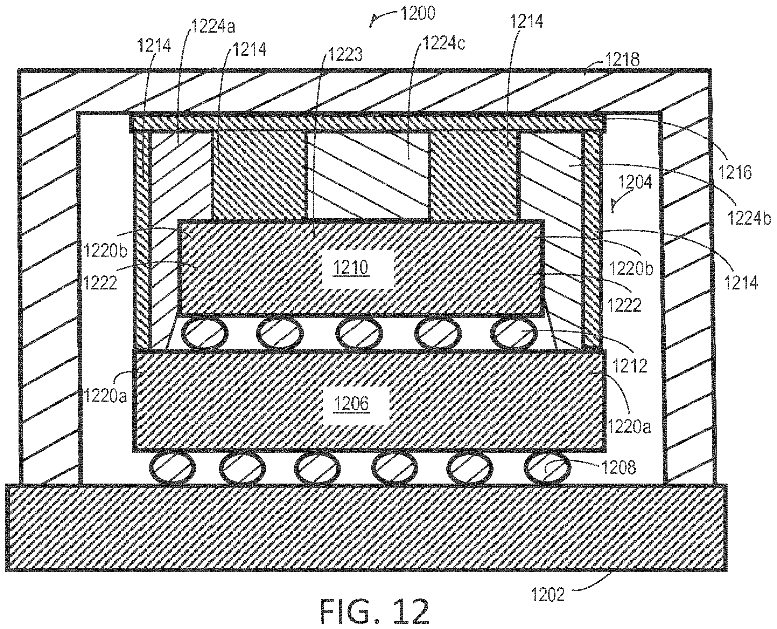

FIG. 12 is yet another example of a package 1200. The package 1200 similar to the examples of FIGs. 1-3, 4-6, and 7-9 also includes a substrate 1202, electrical components 1204 including bottom semiconductor die 1206, solder bumps 1208, top semiconductor die 1210, solder bumps 1212, and a mold layer 1214, arranged and coupled similarly as shown in FIGs. 1-3, 4-6, and 7-9. In this example, the package 1200 also has a thermal interface material layer 1216, and heat spreader 1218 surrounding the electronic components 1204; however, in this example the top semiconductor die 1210 does not interface directly with the thermal interface material 1216. Instead, the top semiconductor die 1210 is spaced at a distance in the vertical direction away from the thermal interface material 1216. Consequently, hot spots are formed in underhang regions 1220a, 1220b of both the bottom semiconductor die 1206 and top semiconductor die 1210. Additionally, hot spots also are presented in edge regions 1222 of the top semiconductor die 1210 and the top surface region 1223 of the top semiconductor die 1210.

In this embodiment, similar to the embodiment of Fig. 11, first and second sections 1224a and 1224b interface with and extend from the bottom semiconductor die 1206 above an underhang region 1220a of the bottom semiconductor die 1206 to an edge region 1222 of the top semiconductor die 1210. The first and second sections 1224a and 1224b also interface with the top semiconductor die 1210 above the underhang region 1220b and extend to the thermal interface material 1216 of the heat spreader 1218. Meanwhile, a third section 1224c interfaces with the top semiconductor die 1210 and extends from over the top surface region 1223 of the top semiconductor die 1210 to the thermal interface material 1216 of the heat spreader 1218. Thus again, the sections vary in position, size, and shape as required for the package 1200. As with the embodiment of FIG. 11, while continuous sections that extend over multiple semiconductor dies are presented, in other embodiments separate spaced sections are provided for each semiconductor die.

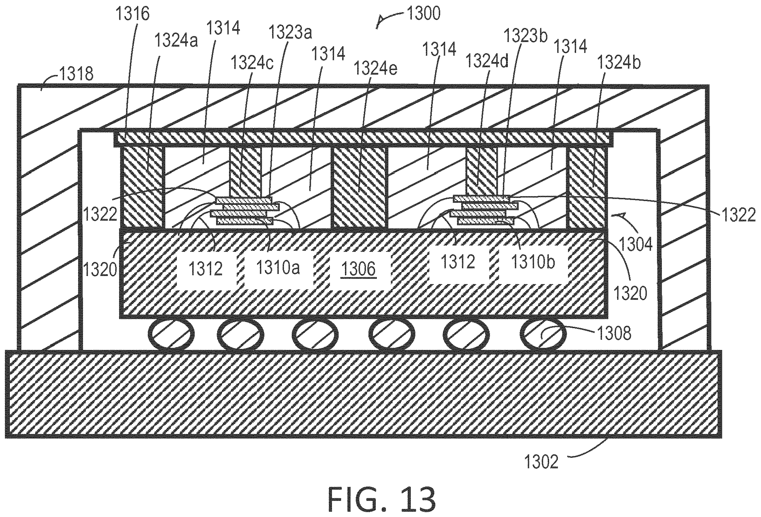

Fig. 13 illustrates yet another package 1300. The package 1300, similar to the examples of Figs. 1-3, 4-6, and 7-9 also includes a substrate 1302, electrical components 1304 including bottom semiconductor die 1306 and solder bumps 1308 arranged and coupled similarly as shown in FIGs. 1-3, 4-6 and 7-9. In this example, semiconductor die stacks 1310a, 1310b are placed on the bottom semiconductor die 1306 and wire bonded with wire elements 1312 to the bottom semiconductor die 1306. The bottom die 1306 may have through-thickness interconnects, including but not limited to through silicon vias (TSVs), that electrically couple its top and bottom sides and which are not shown in the figure. The semiconductor die stacks 1310a, 1310b are also in spaced relation to a thermal interface material layer 1316 of a heat spreader 1318 that surrounds the electronic components 1304 and is coupled to the substrate 1302 similar to the previous examples of FIGs. 1-3, 4-6, and 7-9. Consequently, not only are there hot spots in the underhang regions 1320 and edge regions 1322, but additionally in the top surface regions 1323a, 1323b of the die stacks 1310a, 1310b.

In this example, thermal conductive material sections 1324a, 1324b, 1324c, 1324d, and 1324e again are applied in pre-selected areas within the mold layer 1314. In this example first and second sections 1324a and 1324b interface with and extend from the bottom semiconductor die 1306 above an underhang region of the bottom semiconductor die 1306 to the thermal interface material layer 1316 of the heat spreader 1318. In addition, third and fourth sections 1324c and 1324d are spaced from the first and second sections 1324a and 1324b and one another, and interface with and extend from the top surface regions 1323a and 1323b of the first and second semiconductor die stacks 1310a and 1310b to the thermal interface material layer 1316 of the heat spreader 1318. Finally, the fifth section 1324e is spaced from the other sections and extends from the bottom semiconductor die 1306 to the thermal interface material layer 1316 of the heat spreader 1318 between the first and second die stacks 1310a and 1310b. Therefore, this example illustrates spaced separate sections. However, some sections could be combined such that continuous tapering sections are used as shown in the examples of FIGs. 11 and 12 instead depending on manufacturing and packaging requirements. Thus again, the sections vary in position, size, and shape as required for the package 1300 and to simplify manufacturing processes.

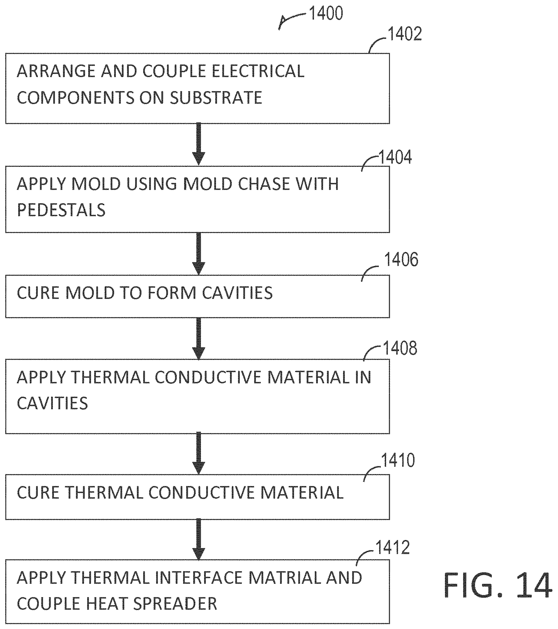

FIG. 14 illustrates an example method of manufacturing a stacked die package 1400. At 1402, a stacked die package is arranged and coupled on a substrate. This arrangement may include any of the arrangements shown in examples 7-13, including but not limited to 2-tier packages, 3-tier packages, exposed top die packages, flip chip bonded packages, wire bonded packages, and the like. At 1404, using a mold chase with protruding pedestals, a mold is applied to encapsulate the electrical components within the package. At 1406, the mold is cured with a plurality of cavities formed in the regions determined to cause hot spots in the package. At 1408, a thermal conductive material is applied in the cavities. This is accomplished through any manner, including, but not limited to dispensing, screen printing, metal plating, and the like. Optionally, at 1410, the thermal conductive material is cured to form thermal conductive material sections within the package. In certain embodiments such as when the thermal conductive material is metal plating that is deposited, such curing is not required. At 1412, a thermal interface material is applied and a heat spreader is coupled to the substrate surrounding the electrical components and interfaces with the thermal conductive material sections and the top die through the thermal interface material.

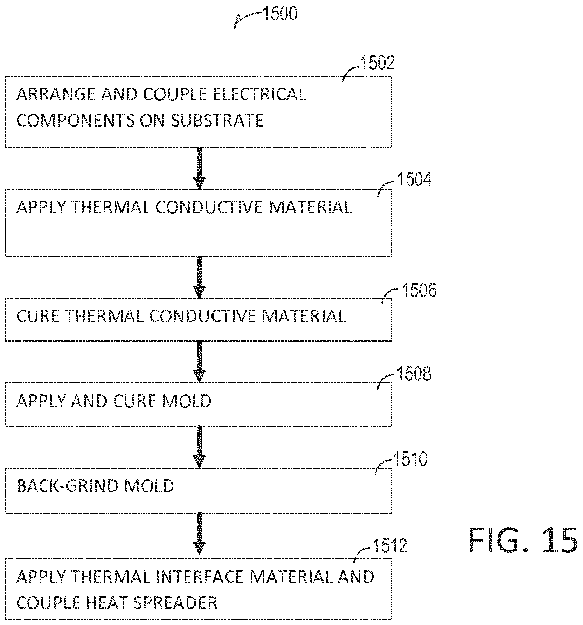

FIG. 15 illustrates another example method of manufacturing a stacked die package. At 1502, a stacked die package is arranged and coupled on a substrate. This arrangement may include any of the arrangements shown in examples 7-13, including but not limited to 2-tier packages, 3-tier packages, exposed top die packages, flip chip bonded packages, wire bonded packages, and the like. At 1504, a thermal conductive material is applied to selected areas in the package determined to cause hot spots in the package. This is accomplished through any manner, including, but not limited to dispensing, screen printing, metal plating and the like. Optionally, at 1506, the thermal conductive material is cured, resulting in the formation of thermal conductive material sections. In certain embodiments such as when the thermal conductive material is metal plating that is deposited, such curing is not required. At 1508, a mold is applied to encapsulate the electrical components and thermal conductive material sections and then cured. At 1510, the mold is back-grinded through any known method to expose the thermal conductive material sections and/or the top die. At 1512, a thermal interface material is applied and a heat spreader is coupled to the substrate surrounding the electrical components and interfaces with the thermal conductive material sections and the top die through the thermal interface material.

With regard to the methods of FIGs. 14-15 the thermal conductive material is applied in a single step. This prevents the need for placing multiple singulated dummy dies in different locations before the molding step. This, in turn, speeds up manufacturing time and reduces manufacturing costs. Additionally, improved heat transfer properties are realized within the package, especially in edge regions which are too small or narrow to accommodate the placement of a dummy die.

Moreover, by applying the thermal conductive material using an additive deposition approach like dispensing or stencil printing, or a semi-additive approach like plating, the material is applied selectively in specific areas that correspond to hot spots or other thermal bottlenecks. This enables the material to create thermal relief paths to otherwise hard to reach locations in a package. This is done while also minimizing the material waste and allowing design optimization for structural and mechanical response. This flexibility is not available when applying a high conductivity mold to encapsulate the package using a blanket molding step. Thus, a package with improved thermomechanical response is realized.

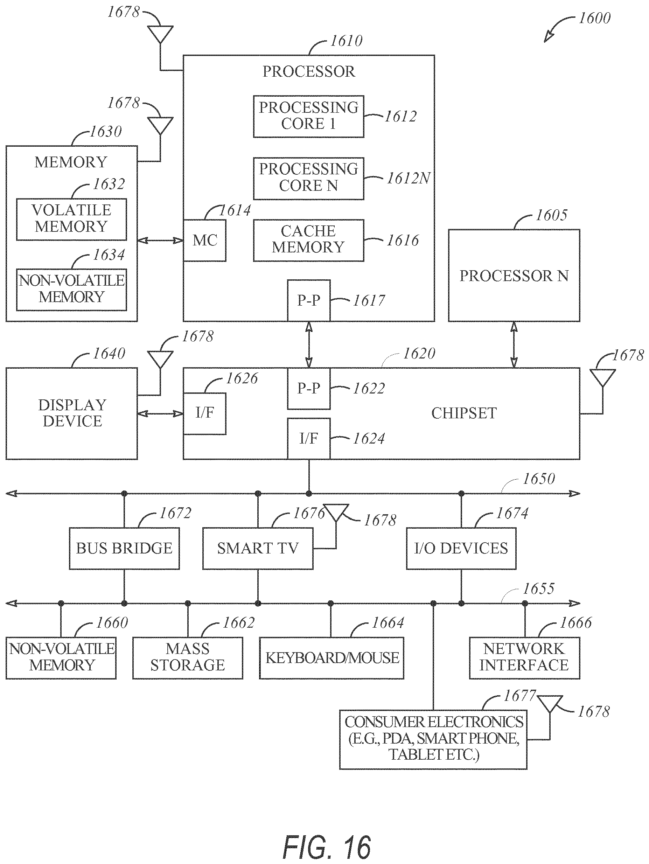

FIG. 16 illustrates a system level diagram, depicting an example of an electronic device (e.g., system) including CPUs and processors, graphics devices, memories, and the like. FIG. 16 is included to show an example of a higher level device application for the packages 700, 1000, 1100, 1200, and 1300 as described in the present disclosure. In one embodiment, system 1600 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 1600 is a system on a chip (SOC) system.

In one embodiment, processor 1610 has one or more processor cores 1612 and 1612N, where 1612N represents the Nth processor core inside processor 1610 where N is a positive integer. In one embodiment, system 1600 includes multiple processors including 1610 and 1605, where processor 1605 has logic similar or identical to the logic of processor 1610. In some embodiments, processing core 1612 includes, but is not limited to, pre-fetch logic to fetch instructions, decode logic to decode the instructions, execution logic to execute instructions and the like. In some embodiments, processor 1610 has a cache memory 1616 to cache instructions and/or data for system 1600. Cache memory 1616 may be organized into a hierarchal structure including one or more levels of cache memory.

In some embodiments, processor 1610 includes a memory controller 1614, which is operable to perform functions that enable the processor 1610 to access and communicate with memory 1630 that includes a volatile memory 1632 and/or a non-volatile memory 1634. In some embodiments, processor 1610 is coupled with memory 1630 and chipset 1620. Processor 1610 may also be coupled to a wireless antenna 1678 to communicate with any device configured to transmit and/or receive wireless signals. In one embodiment, an interface for wireless antenna 1678 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 1632 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 1634 includes, but is not limited to, flash memory, phase change memory (PCM), read-only memory (ROM), electrically erasable programmable read-only memory (EEPROM), or any other type of non-volatile memory device.

Memory 1630 stores information and instructions to be executed by processor 1610. In one embodiment, memory 1630 may also store temporary variables or other intermediate information while processor 1610 is executing instructions. In the illustrated embodiment, chipset 1620 connects with processor 1610 via Point-to-Point (PtP or P-P) interfaces 1617 and 1622. Chipset 1620 enables processor 1610 to connect to other elements in system 1600. In some embodiments of the example system, interfaces 1617 and 1622 operate in accordance with a PtP communication protocol such as the Intel® QuickPath Interconnect (QPI) or the like. In other embodiments, a different interconnect may be used.

In some embodiments, chipset 1620 is operable to communicate with processor 1610, 1605N, display device 1640, and other devices, including a bus bridge 1672, a smart TV 1676, I/O devices 1674, nonvolatile memory 1660, a storage medium (such as one or more mass storage devices) 1662, a keyboard/mouse 1664, a network interface 1666, and various forms of consumer electronics 1677 (such as a PDA, smart phone, tablet etc.), etc. In one embodiment, chipset 1620 couples with these devices through an interface 1624. Chipset 1620 may also be coupled to a wireless antenna 1678 to communicate with any device configured to transmit and/or receive wireless signals.

Chipset 1620 connects to display device 1640 via interface 1626. Display 1640 may be, for example, a liquid crystal display (LCD), a light emitting diode (LED) array, an organic light emitting diode (OLED) array, or any other form of visual display device. In some embodiments of the example system, processor 1610 and chipset 1620 are merged into a single SOC. In addition, chipset 1620 connects to one or more buses 1650 and 1655 that interconnect various system elements, such as I/O devices 1674, nonvolatile memory 1660, storage medium 1662, a keyboard/mouse 1664, and network interface 1666. Buses 1650 and 1655 may be interconnected together via a bus bridge 1672.

In one embodiment, mass storage device 1662 includes, but is not limited to, a solid state drive, a hard disk drive, a universal serial bus flash memory drive, or any other form of computer data storage medium. In one embodiment, network interface 1666 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in FIG. 16 are depicted as separate blocks within the system 1600, the functions performed by some of these blocks may be integrated within a single semiconductor circuit or may be implemented using two or more separate integrated circuits. For example, although cache memory 1616 is depicted as a separate block within processor 1610, cache memory 1616 (or selected aspects of 1616) can be incorporated into processor core 1612.

### VARIOUS NOTES & EXAMPLES

Example 1 is a semiconductor device comprising: a semiconductor die coupled to a substrate; a mold compound encapsulating the semiconductor die; at least one thermal conductive material section extending from adjacent the semiconductor die through the mold compound to convey heat from the semiconductor die through the mold compound.
In Example 2, the subject matter of Example 1 optionally includes wherein a thermal conductivity of the at least one thermal conductive material section is greater than a thermal conductivity of the mold compound.
In Example 3, the subject matter of any one or more of Examples 1-2 optionally include a heat spreader interfacing with the thermal conductive material section to receive heat conveyed through the thermal conductive material section.
In Example 4, the subject matter of any one or more of Examples 1-3 optionally include wherein the semiconductor die is within a stacked semiconductor die set.
In Example 5, the subject matter of Example 4 optionally includes wherein the stacked semiconductor die set includes a bottom semiconductor die coupled to the substrate and a top semiconductor die coupled to the bottom semiconductor die.
In Example 6, the subject matter of Example 5 optionally includes wherein the at least one thermal conductive material section interfaces with the bottom semiconductor die and the top semiconductor die and extends to a heat spreader coupled to the substrate.
In Example 7, the subject matter of any one or more of Examples 4-6 optionally include wherein the stacked semiconductor die set includes an intermediary semiconductor die coupled to the bottom semiconductor die and a top semiconductor die coupled to the intermediary semiconductor die.
In Example 8, the subject matter of Example 7 optionally includes wherein the at least one thermal conductive material section includes a first thermal conductive material section interfacing with the bottom semiconductor die and a second thermal conductive material section interfacing with the intermediary semiconductor die.
In Example 9, the subject matter of any one or more of Examples 1-8 optionally include wherein the at least one thermal conductive material section includes a first thermal conductive material section and a spaced apart second thermal conductive material section.
In Example 10, the subject matter of Example 9 optionally includes wherein the first thermal conductive material section comprises a different thermal conductive material than thermal conductive material of the second thermal conductive material section.
In Example 11, the subject matter of any one or more of Examples 5-10 optionally include wherein the stacked semiconductor die set includes a first top semiconductor die coupled to the bottom semiconductor die and a second top semiconductor die spaced from the first top semiconductor die and coupled to the bottom semiconductor die.
In Example 12, the subject matter of Example 11 optionally includes wherein the first top semiconductor die is a processor and the second top semiconductor die is a memory.
In Example 13, the subject matter of any one or more of Examples 5-12 optionally include wherein the top semiconductor die is within a semiconductor die stack.
Example 14 is a semiconductor device comprising: a bottom semiconductor die coupled to a substrate; a first top semiconductor die coupled to the bottom semiconductor die; a second top semiconductor die coupled to the bottoms semiconductor die and spaced from the first semiconductor die; a mold compound encapsulating the semiconductor die; at least one thermal conductive material section extending from adjacent the bottom semiconductor die and extending through the mold compound adjacent one of the first or second top semiconductor dies to convey heat through the mold compound.
In Example 15, the subject matter of Example 14 optionally includes wherein the at least one thermal conductive material section extends through the mold compound between the first semiconductor die and the second semiconductor die.
In Example 16, the subject matter of any one or more of Examples 14-15 optionally include wherein the at least one thermal conductive material section extends through the mold compound from adjacent the first top semiconductor die to adjacent the second top semiconductor die.
In Example 17, the subject matter of any one or more of Examples 14-16 optionally include wherein the at least one thermal conductive material section comprises: a first thermal conductive material section extending through the mold compound from adjacent the bottom semiconductor die and extending through the mold compound adjacent the first top semiconductor die; and a second thermal conductive material section extending through the mold compound from adjacent the bottom semiconductor die and extending through the mold compound adjacent the second top semiconductor die spaced from the first thermal conductive material section.
Example 18 is a method of forming a semiconductor device, the method comprising: coupling a semiconductor die to a substrate; applying at least one thermal conductive material section adjacent the semiconductor die; and encapsulating the semiconductor die and the thermal conductive material with a mold layer.
In Example 19, the subject matter of Example 18 optionally includes wherein applying at least one thermal conductive material section comprises printing thermal conductive material on the substrate or the semiconductor die.
In Example 20, the subject matter of any one or more of Examples 18-19 optionally include wherein applying at least one thermal conductive material section comprises plating the thermal conductive material onto the substrate or semiconductor die.
In Example 21, the subject matter of any one or more of Examples 18-20 optionally include wherein applying at least one thermal conductive material section comprises depositing a thermal conductive material on the substrate or semiconductor die; and curing the thermal conductive material to form the at least one thermal conductive material section.
In Example 22, the subject matter of any one or more of Examples 18-21 optionally include wherein encapsulating the semiconductor die and thermal conductive material with a mold layer comprises applying mold material over the semiconductor die and the thermal conductive material; and curing the mold material to form the mold layer.
In Example 23, the subject matter of any one or more of Examples 18-22 optionally include coupling a heat spreader to the substrate in spaced relation to the semiconductor die.
In Example 24, the subject matter of Example 23 optionally includes wherein the at least one thermal conductive material section extends between the semiconductor die and the heat spreader.
In Example 25, the subject matter of any one or more of Examples 18-24 optionally include grinding the mold layer to expose the thermal conductive material and the semiconductor die.

Each of these non-limiting examples may stand on its own, or may be combined in various permutations or combinations with one or more of the other examples.

The above detailed description includes references to the accompanying drawings, which form a part of the detailed description. The drawings show, by way of illustration, specific embodiments in which the invention may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein may be machine or computer-implemented at least in part. Some examples may include a computer-readable medium or machine-readable medium encoded with instructions operable to configure an electronic device to perform methods as described in the above examples. An implementation of such methods may include code, such as microcode, assembly language code, a higher-level language code, or the like. Such code may include computer readable instructions for performing various methods. The code may form portions of computer program products. Further, in an example, the code may be tangibly stored on one or more volatile, non-transitory, or non-volatile tangible computer-readable media, such as during execution or at other times. Examples of these tangible computer-readable media may include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments may be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments may be combined with each other in various combinations or permutations. The scope of the invention should be determined with reference to the appended claims, along with the full scope of equivalents to which such claims are entitled.

## Claims

1. A method of forming a semiconductor device, the method comprising:
coupling a semiconductor die to a substrate;
applying at least one thermal conductive material section adjacent the semiconductor die; and
encapsulating the semiconductor die and the thermal conductive material with a mold layer.

2. The method of claim 1 wherein applying at least one thermal conductive material section comprises printing thermal conductive material on the substrate or the semiconductor die.

3. The method of claim 1 wherein applying at least one thermal conductive material section comprises plating the thermal conductive material onto the substrate or semiconductor die.

4. The method of claim 1 wherein applying at least one thermal conductive material section comprises depositing a thermal conductive material on the substrate or semiconductor die; and curing the thermal conductive material to form the at least one thermal conductive material section.

5. The method of any of claims 1-4 wherein encapsulating the semiconductor die and thermal conductive material with a mold layer comprises applying mold material over the semiconductor die and the thermal conductive material; and curing the mold material to form the mold layer.

6. The method of any of claims 1-5 further comprising:
coupling a heat spreader to the substrate in spaced relation to the semiconductor die.

7. The method of any of claims 1-6 wherein the at least one thermal conductive material section extends between the semiconductor die and the heat spreader.

8. The method of any of claims 1-7 wherein the semiconductor die is a first top semiconductor die of a stacked semiconductor die set and coupling the semiconductor die to the substrate comprises coupling the first top semiconductor die of the stacked semiconductor set to a bottom semiconductor die of the stacked semiconductor die set.

9. The method of any of claims 1-8 wherein applying the at least one thermal conductive material section includes applying the at least one thermal conductive material section between the first top semiconductor die of the stacked semiconductor die set and a second top semiconductor die of the stacked semiconductor die set that is coupled to the bottom semiconductor die of the stacked semiconductor die set.

10. The method of any of claims 1-7 wherein the semiconductor die is a top semiconductor die of a stacked semiconductor die set and coupling the semiconductor die to the substrate comprises coupling the top semiconductor die of the stacked semiconductor set to an intermediary semiconductor die of the stacked semiconductor die set; and coupling the intermediary semiconductor die of the stacked semiconductor die set to a bottom semiconductor die of the stacked semiconductor set.

11. The method of any of claims 1-10 wherein the at least one thermal conductive material section has a thermal conductivity greater than a thermal conductivity of the mold layer.

12. The method of any of claims 1-7 wherein the semiconductor die is within a semiconductor die stack.

13. The method of any of claims 1-12 wherein the at least one thermal conductive material section is elongated with arcuate end walls.

14. The method of any of claims 1-13 further comprising:
grinding the mold layer to expose the thermal conductive material and the semiconductor die.

15. An apparatus comprising means to perform any of the methods 1-14.
